# EUROPEAN PATENT APPLICATION

(11) **EP 4 597 592 A1**
(43) Date of publication of application: **06.08.2025**
(21) Application number: 23929498.6
(22) Date of filing: 31.03.2023
(51) Int. Cl.: H01L 33/62

(54) **LIGHT-EMITTING DEVICE, DISPLAY APPARATUS, AND BACKLIGHT APPARATUS**

(71) Applicant: Boe Technology Group Co., Ltd., Beijing 100015 (CN); BOE MLED Technology Co., Ltd., Beijing 100176 (CN)
(72) Inventor: LU, Yuanda, Beijing 100176 (CN); CHU, Yutian, Beijing 100176 (CN); ZHAO, Jiawei, Beijing 100176 (CN); XIONG, Zhijun, Beijing 100176 (CN); SUN, Yuanhao, Beijing 100176 (CN); CHEN, Zedan, Beijing 100176 (CN); FAN, Qi, Beijing 100176 (CN); MA, Junjie, Beijing 100176 (CN)
(74) Representative: Brötz, Helmut
(86) International application number: PCT/CN2023/085742
(87) International publication number: WO 2024/197915

(57) **Abstract**

A light-emitting device, a display apparatus, and a backlight apparatus. The light-emitting device comprises a light-emitting sub-unit; and the light-emitting sub-unit comprises a first semiconductor layer, a second semiconductor layer, a light-emitting layer, and a protective layer. The second semiconductor layer and the first semiconductor layer are stacked and the material of the second semiconductor layer is different from that of the first semiconductor layer; the light-emitting layer is located between the first semiconductor layer and the second semiconductor layer and is configured to emit light; the protective layer is located on the side of the first semiconductor layer distant from the second semiconductor layer; the first semiconductor layer comprises a central area and an edge area surrounding the central area; the protective layer at least covers the central area; the central area comprises a first action area; and when an ejector pin is used for transferring the light-emitting device, the ejector pin is located in the first action area.

## Description

### TECHNICAL FIELD

Embodiments of the present disclosure relate to a light-emitting device, a display apparatus, and a backlight apparatus.

### BACKGROUND

LED (Light Emitting Diode) has advantages of low cost, high light efficiency, energy conservation and environmental protection, and is widely used in lighting, visible light communication, and light-emitting display scenarios.

One development direction of LED is towards miniaturization and microminiaturization. After miniaturization, LED forms arrays with millimeter or even micrometer gaps, which can achieve ultra-high resolution and can be more widely used in fields such as information display.

At present, small-sized inverted LED chips have been widely used in backlight and RGB display apparatus, and currently, in display products on the market, thousands or tens of thousands of inverted LED chips with a single light-emitting unit, or inverted LED chips with two light-emitting units connected in series, are installed upside down on the circuit board. The smaller the chip size, the closer the distance between the chips, and the higher the final displayed contrast.

When thousands or tens of thousands of inverted LED chips are transferred to the circuit board for further installation to form a display panel, it is necessary to use a needle of a transfer device to act on the central region of the front side of the inverted LED chip to lift it up and transfer it, which requires higher technology and cost. Currently, there are problems such as low transfer yield and low needle alignment accuracy. Moreover, the needle can easily cause damage to the top structure of the LED chip, thereby affecting the light-emitting efficiency of the LED chip and even damaging the LED chip.

### SUMMARY

At least one embodiment of the present disclosure provides a light-emitting device, the light-emitting device comprises a sub light-emitting unit; the sub light-emitting unit comprises: a first semiconductor layer, a second semiconductor layer, a light-emitting layer, and a protection layer. The second semiconductor layer is stacked with the first semiconductor layer and being made of a different material from the first semiconductor layer; the light-emitting layer is between the first semiconductor layer and the second semiconductor layer; the protection layer is on a side of the first semiconductor layer away from the second semiconductor layer; the first semiconductor layer comprises a central region and an edge region around the central region, the protection layer at least covers the central region, and the central region comprises a first action region, upon a needle being used to transfer the light-emitting device, the needle is located in the first action region.

For example, in the light-emitting device provided by at least an embodiment of the present disclosure, the first semiconductor layer has an upper surface away from the second semiconductor layer, and an area of a portion of the upper surface of the first semiconductor layer covered by the protection layer accounts for no less than 1/2 of an area of an upper surface of the second semiconductor layer.

For example, in the light-emitting device provided by at least an embodiment of the present disclosure, the protection layer covers an entirety of the first semiconductor layer.

For example, the light-emitting device provided by at least an embodiment of the present disclosure further comprises a current expansion layer, the current expansion layer is stacked with the first semiconductor layer and the second semiconductor layer, on the side of the first semiconductor layer away from the second semiconductor layer, and at least partially in contact with the first semiconductor layer to be electrically connected to each other; the current expansion layer comprises a needle action portion in the central region, and the protection layer at least covers the needle action portion of the current expansion layer.

For example, in the light-emitting device provided by at least an embodiment of the present disclosure, the protection layer covers an entirety of the current expansion layer.

For example, the light-emitting device provided by at least an embodiment of the present disclosure further comprises a first insulation layer, the protection layer is floating, and the protection layer that is floating and the first semiconductor layer are separated by the first insulation layer to insulate with each other.

For example, in the light-emitting device provided by at least an embodiment of the present disclosure, the first insulation layer wraps around an entirety of the protection layer that is floating, covers and contacts a lower surface of a reflection layer that is floating close to the first semiconductor layer, an upper surface opposite to the lower surface, and a side surface intersecting both the upper surface of the reflection layer that is floating and the lower surface of the reflection layer that is floating.

For example, the light-emitting device provided by at least an embodiment of the present disclosure further comprises a first bridge electrode, a first electrode, and a second electrode. The first bridge electrode is on the side of the first semiconductor layer away from the second semiconductor layer, and insulated from the second semiconductor layer through an interlayer insulation layer; the first electrode is electrically connected to the first semiconductor layer through the first bridge electrode; and the second electrode is electrically connected to the second semiconductor layer; the first bridge electrode is further used as the protection layer, and no edge of the first bridge electrode is within the first action region where the needle is located.

For example, in the light-emitting device provided by at least an embodiment of the present disclosure, a portion of the first bridge electrode that covers the first action region where the needle is located does not cover an edge of the interlayer insulation layer and has a flat surface.

For example, the light-emitting device provided by at least an embodiment of the present disclosure further comprises a first electrode and a second electrode. The first electrode is electrically connected to the first semiconductor layer; the second electrode is electrically connected to the second semiconductor layer, a direction in which the first semiconductor layer and the second semiconductor layer are stacked with each other is a vertical direction, and an orthographic projection of the first electrode on a horizontal plane perpendicular to the vertical direction at least partially overlaps with an orthographic projection of the first semiconductor layer on the horizontal plane, and the first electrode is directly electrically connected to the first semiconductor layer through a via; the light-emitting device further comprises a current expansion layer, the current expansion layer is stacked with the first semiconductor layer and the second semiconductor layer, is on the side of the first semiconductor layer away from the second semiconductor layer, and is at least partially in contact with the first semiconductor layer to be electrically connected to each other, the current expansion layer comprises a needle action portion in the central region; a surface of the current expansion layer away from the first semiconductor layer is a flat surface, and the current expansion layer is further used as the protection layer, or, the light-emitting device further comprises a first insulation layer, the protection layer is a reflection layer that is floating, and the reflection layer that is floating and the first semiconductor layer are separated by the first insulation layer to insulate with each other, the protection layer at least covers the needle action portion of the current expansion layer.

For example, the light-emitting device provided by at least an embodiment of the present disclosure further comprises a first bridge electrode, a first electrode, and a second electrode. The first bridge electrode is on the side of the first semiconductor layer away from the second semiconductor layer, and insulated from the second semiconductor layer through an interlayer insulation layer; the first electrode is electrically connected to the first semiconductor layer through the first bridge electrode; the second electrode is electrically connected to the second semiconductor layer, a direction in which the first semiconductor layer and the second semiconductor layer are stacked with each other is a vertical direction, the first bridge electrode is on the side of the first semiconductor layer away from the second semiconductor layer, an orthographic projection of the first bridge electrode on a horizontal plane perpendicular to the vertical direction overlaps with a part of an orthographic projection of the first semiconductor layer on the horizontal plane, and does not overlap with an orthographic projection of the first action region of the central region on the horizontal plane.

For example, in the light-emitting device provided by at least an embodiment of the present disclosure, the orthographic projection of the first bridge electrode extends in a transverse direction towards the orthographic projection of the first semiconductor layer to overlap with the orthographic projection of the first semiconductor layer, and a width of an overlapping part of the orthographic projection of the first bridge electrode and the orthographic projection of the first semiconductor layer in the transverse direction is less than half of a width of the first semiconductor layer in the transverse direction.

For example, in the light-emitting device provided by at least an embodiment of the present disclosure, upon the light-emitting device being transferred using the needle, the needle is located in the first action region, and an edge of the orthographic projection of the first bridge electrode on the horizontal plane close to the first action region comprises a concave portion depressed in a direction away from the first region.

For example, in the light-emitting device provided by at least an embodiment of the present disclosure, a shape of the concave portion of the edge of the orthographic projection of the first bridge electrode on the horizontal plane is complementary to a shape of an outer contour of an edge, opposite to the first bridge electrode, of an orthographic projection in the first action region on the horizontal plane.

For example, in the light-emitting device provided by at least an embodiment of the present disclosure, the shape of the concave portion of the edge of the orthographic projection of the first bridge electrode on the horizontal plane is an arc shape depressed in a direction away from the first action region.

For example, in the light-emitting device provided by at least an embodiment of the present disclosure, the light-emitting device comprises a plurality of sub light-emitting units, each of the sub light-emitting units comprises a first semiconductor layer and a second semiconductor layer stacked with the first semiconductor layer and being made of a different material from the first semiconductor layer, the plurality of sub light-emitting units comprise a sub light-emitting unit for transfer, and the sub light-emitting unit for transfer further comprises the protection layer.

For example, in the light-emitting device provided by at least an embodiment of the present disclosure, odd numbered sub light-emitting units that are continuously arranged constitute a light-emitting unit, and the sub light-emitting unit for transfer is located in a middle position of the odd numbered sub light-emitting units.

For example, in the light-emitting device provided by at least an embodiment of the present disclosure, the plurality of sub light-emitting units comprise a first sub light-emitting unit adjacent to the sub light-emitting unit for transfer;

the light-emitting device further comprises a second bridge electrode, the second bridge electrode electrically connects the first semiconductor layer of the sub light-emitting unit for transfer and the second semiconductor layer of the first sub light-emitting unit.

For example, in the light-emitting device provided by at least an embodiment of the present disclosure, the second bridge electrode is further used as the protection layer.

For example, in the light-emitting device provided by at least an embodiment of the present disclosure, the plurality of sub light-emitting units comprise a second light-emitting unit and a third sub light-emitting unit that are adjacent to each other, a gap is between the second light-emitting unit and the third sub light-emitting unit, and a second action region where the needle is located is within the gap, upon the light-emitting device being transferred using the needle, the needle is located in the second action region; the light-emitting device further comprises a second bridge electrode, the second bridge electrode electrically connects the first semiconductor layer of the second light-emitting unit and the second semiconductor layer of the third sub light-emitting unit, a direction in which the first semiconductor layer and the second semiconductor layer are stacked with each other is a vertical direction, an orthographic projection of the second bridge electrode on a horizontal plane perpendicular to the vertical direction does not overlap with an orthographic projection of the second action region where the needle is located on the horizontal plane.

For example, in the light-emitting device provided by at least an embodiment of the present disclosure, the second light-emitting unit and the third sub light-emitting unit are arranged in a transverse direction, and a direction perpendicular to the transverse direction in an extending plane of the second semiconductor layer is a longitudinal direction; the second bridge electrode extends in the transverse direction and is on a side of the second action region in the longitudinal direction.

For example, in the light-emitting device provided by at least an embodiment of the present disclosure, an edge of an orthographic projection of the second bridge electrode on the horizontal plane close to the second action region comprises a concave portion depressed in a direction away from the second action region.

For example, in the light-emitting device provided by at least an embodiment of the present disclosure, a shape of the concave portion of the edge of the orthographic projection of the second bridge electrode on the horizontal plane is complementary to a shape of an outer contour of an edge, opposite to the second bridge electrode, of an orthographic projection in the second action region on the horizontal plane.

For example, in the light-emitting device provided by at least an embodiment of the present disclosure, a first edge of the second semiconductor layer of the second sub light-emitting unit close to the third sub light-emitting unit in the transverse direction is closer to the gap than a first edge of the first semiconductor layer of the second sub light-emitting unit close to the third sub light-emitting unit in the transverse direction, and a first edge of the second semiconductor layer of the third sub light-emitting unit close to the second sub light-emitting unit in the transverse direction is closer to the gap than a first edge of the first semiconductor layer of the third sub light-emitting unit close to the second sub light-emitting unit in the transverse direction, the first edge of the second semiconductor layer of the second sub light-emitting unit comprises a concave portion depressed in a direction away from the third sub light-emitting unit, and the first edge of the second semiconductor layer of the third sub light-emitting unit comprises a concave portion depressed in a direction away from the second sub light-emitting unit.

For example, in the light-emitting device provided by at least an embodiment of the present disclosure, an edge of the orthographic projection of the first semiconductor layer of the second sub light-emitting unit on the horizontal plane and an edge of the orthographic projection of the first semiconductor layer of the third sub light-emitting unit on the horizontal plane that are opposite to each other respectively comprise a concave portion depressed in a direction away from the gap; and/or, an edge of the orthographic projection of the light-emitting layer of the second sub light-emitting unit on the horizontal plane and an edge of the orthographic projection of the light-emitting layer of the third sub light-emitting unit on the horizontal plane that are opposite to each other respectively comprise a concave portion depressed in a direction away from the gap.

For example, in the light-emitting device provided by at least an embodiment of the present disclosure, a cross-section of the second bridge electrode along the vertical direction comprises a first sloping surface, an included angle between the first sloping surface and a horizontal direction is less than or equal to 70°, and the horizontal direction is perpendicular to the vertical direction.

For example, in the light-emitting device provided by at least an embodiment of the present disclosure, a direction in which the first semiconductor layer and the second semiconductor layer are stacked with each other is a vertical direction, and a cross-section of the second semiconductor layer along the vertical direction comprises a second sloping surface, an included angle between the second sloping surface and a horizontal direction is less than or equal to 70°, and the horizontal direction is perpendicular to the vertical direction.

For example, in the light-emitting device provided by at least an embodiment of the present disclosure, the light-emitting device is a mini light-emitting diode (Mini LED) or a micro light-emitting diode (Micro LED); a material of the current expansion layer is a transparent conductive material; the first semiconductor material is a P-type semiconductor material, and the second semiconductor material is an N-type semiconductor material, or, the first semiconductor material is an N-type semiconductor material, and the second semiconductor material is a P-type semiconductor material.

At least one embodiment of the present further disclosure provides a light-emitting device, the light-emitting device comprises a plurality of sub light-emitting unit, each of the sub light-emitting units comprises a first semiconductor layer, a second semiconductor layer, and a light-emitting layer. The second semiconductor layer is stacked with the first semiconductor layer and being made of a different material from the first semiconductor layer; the light-emitting layer is between the first semiconductor layer and the second semiconductor layer and configured to emit light, the plurality of sub light-emitting units comprise a second light-emitting unit and a third sub light-emitting unit that are adjacent to each other, a gap is between the second light-emitting unit and the third sub light-emitting unit, a second action region where the needle is located is within the gap, and upon the light-emitting device being transferred using the needle, the needle is located in the second action region; the light-emitting device further comprises a second bridge electrode, the second bridge electrode electrically connects the first semiconductor layer of the second light-emitting unit and the second semiconductor layer of the third sub light-emitting unit, a direction in which the first semiconductor layer and the second semiconductor layer are stacked with each other is a vertical direction, an orthographic projection of the second bridge electrode on a horizontal plane perpendicular to the vertical direction does not overlap with an orthographic projection of the second action region where the needle is located on the horizontal plane.

At least one embodiment of the present further disclosure provides a display apparatus, and the display apparatus comprises any one of the light-emitting devices provided by the embodiments of the present disclosure.

At least one embodiment of the present further disclosure provides a backlight apparatus, and the backlight apparatus comprises any one of the light-emitting devices provided by the embodiments of the present disclosure.

At least one embodiment of the present further disclosure provides an electronic apparatus, and the electronic apparatus comprises any one of the backlight apparatus provided by the embodiments of the present disclosure.

### BRIEF DESCRIPTION OF DRAWINGS

In order to clearly illustrate technical solutions of the embodiments of the present disclosure, the drawings of the embodiments will be briefly described. It is obvious that the described drawings in the following are only related to some embodiments of the present disclosure and thus are not construed as any limitation to the present disclosure.
Fig. 1A is a schematic diagram of a planar structure of a light-emitting device provided by an embodiment of the present disclosure;
Fig. 1B is a schematic cross-sectional diagram along a line A-A' in Fig. 1A;
Fig. 1C is a schematic diagram of a light-emitting device including odd numbered sub light-emitting units provided by an embodiment of the present disclosure;
Fig. 2A is a schematic diagram of a planar structure of another light-emitting device provided by an embodiment of the present disclosure;
Fig. 2B is a schematic cross-sectional diagram of the light-emitting device in Fig. 2A;
Fig. 3A is a schematic diagram of a planar structure of another light-emitting device provided by an embodiment of the present disclosure;
Fig. 3B is a schematic cross-sectional diagram of the light-emitting device in Fig. 3A;
Fig. 4A is a schematic diagram of a planar structure of another light-emitting device provided by an embodiment of the present disclosure;
Fig. 4B is a schematic cross-sectional diagram of the light-emitting device in Fig. 4A;
Fig. 5A is a schematic diagram of a planar structure of another light-emitting device provided by an embodiment of the present disclosure;
Fig. 5B is a schematic cross-sectional diagram of the light-emitting device in Fig. 5A;
Fig. 6A is a schematic cross-sectional diagram of another light-emitting device provided by an embodiment of the present disclosure;
Fig. 6B is a schematic cross-sectional diagram of another light-emitting device provided by an embodiment of the present disclosure;
Fig. 7A is a schematic diagram of a planar structure of another light-emitting device provided by an embodiment of the present disclosure;
Fig. 7B is a schematic cross-sectional diagram of the light-emitting device in Fig. 7A;
Fig. 8A is a schematic diagram of a planar structure of another light-emitting device provided by an embodiment of the present disclosure;
Fig. 8B is a schematic cross-sectional diagram of the light-emitting device in Fig. 8A;
Fig. 9 is a schematic diagram of a planar structure of another light-emitting device provided by an embodiment of the present disclosure;
Fig. 10 is a schematic diagram of a planar structure of a light-emitting device including even numbered sub light-emitting units provided by an embodiment of the present disclosure;
Fig. 11 is a schematic cross-sectional diagram along a line D-D' in Fig. 11;
Fig. 12 is a schematic block diagram of a display apparatus provided by an embodiment of the present disclosure; and
Fig. 13 is a schematic diagram of a backlight apparatus provided by an embodiment of the present disclosure.

### DETAILED DESCRIPTION

In order to make objectives, technical details, and advantages of the embodiments of the present disclosure clearer, the technical solutions of the embodiments will be described in a clearly and fully understandable way in connection with the drawings related to the embodiments of the present disclosure. Apparently, the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first", "second", etc., which are used in the present disclosure, are not intended to indicate any sequence, amount or importance, but distinguish various components. Also, the terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly. "On," "under," "left," "right" and the like are only used to indicate relative position relationship, and when the position of the object which is described is changed, the relative position relationship may be changed accordingly.

Features such as "parallel", "vertical" and "identical" used in the present disclosure all include situations where the features "parallel", "vertical" and "identical" are in a strict sense, as well as situations where the features "basically parallel", "basically overlapping" and "basically identical" contain certain errors. Considering the measurement and the error related to the measurement of a specific quantity (for example, the limitation of the measurement system), it is within the acceptable deviation range for a specific value determined by ordinary people in the field. For example, the feature "substantially" may mean within one or more standard deviations, and may mean within 10% or 5% deviation of the stated value unless otherwise specified.

In the present disclosure, the term "floating" refers to the floating structure not being connected to other conductive structures and not transmitting electrical signals.

During the process of using the needle of a transfer device to act on the central region of the front side of the inverted LED light-emitting device, to lift the LED light-emitting device up and transfer the LED light-emitting device, the needle is prone to damage the top structure of the LED light-emitting device, thereby affecting the LED light-emitting device and causing abnormal operation of the LED light-emitting device, such as insulation layer rupture, which leads to current leakage, thereby affecting the light-emitting efficiency, even causing the bridge electrode to break, and thus the signal transmission efficiency is reduced, and even causing damage to the electrode which is close to the top and used to control light-emitting. The region where the needle is located during the transfer process is called the needle action region, especially when the needle action region is not flat, it is particularly easy to cause the layer close to the top of the inverted LED chip to break, leading to abnormal operation of the above-mentioned LED light-emitting device. Therefore, during the process of using the needle to transfer the LED light-emitting device, it is very important to prevent the layer in the action region where the needle is located from being damaged, to improve the transfer success rate and ensure the normal operation of the LED light-emitting device.

At least one embodiment of the present disclosure provides a light-emitting device, the light-emitting device comprises a sub light-emitting unit; the sub light-emitting unit comprises: a first semiconductor layer, a second semiconductor layer, a light-emitting layer, and a protection layer. The second semiconductor layer is stacked with the first semiconductor layer and being made of a different material from the first semiconductor layer; the light-emitting layer is between the first semiconductor layer and the second semiconductor layer; the protection layer is on a side of the first semiconductor layer away from the second semiconductor layer; the first semiconductor layer comprises a central region and an edge region around the central region, the protection layer at least covers the central region, and the central region comprises a first action region, upon a needle being used to transfer the light-emitting device, the needle is located in the first action region.

At least one embodiment of the present disclosure further provides a display apparatus, the display apparatus includes any one of the light-emitting devices provided by the embodiments of the present disclosure.

At least one embodiment of the present disclosure further provides a backlight apparatus, the backlight apparatus includes any one of the light-emitting devices provided by the embodiments of the present disclosure.

At least one embodiment of the present disclosure further provides an electronic apparatus, the electronic apparatus includes any one of the backlight apparatus provided by the embodiments of the present disclosure.

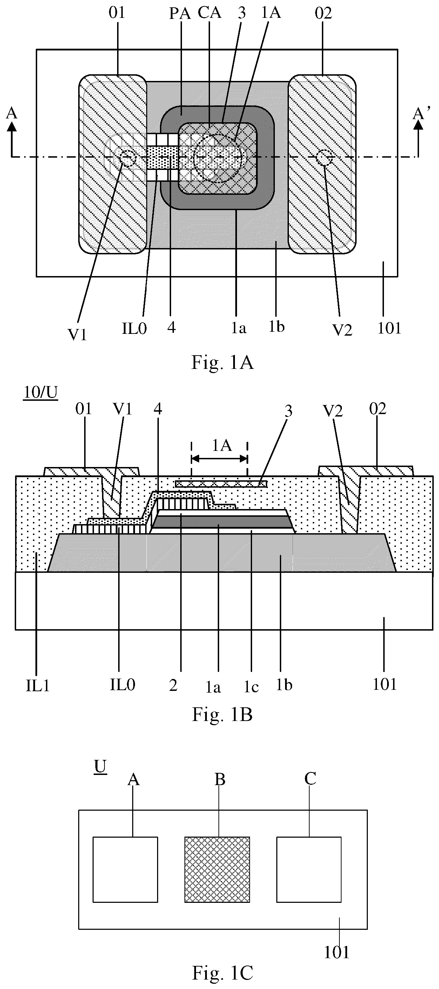

Exemplarily, Fig. 1A is a schematic diagram of a planar structure of a light-emitting device provided by an embodiment of the present disclosure, and Fig. 1B is a schematic cross-sectional diagram along a line A-A' in Fig. 1A. Referring to Figs. 1A-1B, the light-emitting device 10 includes a sub light-emitting unit U, the sub light-emitting unit U includes a first semiconductor layer 1a, a second semiconductor layer 1b, a light-emitting layer 1c, and a protection layer 3. The second semiconductor layer 1b is stacked with the first semiconductor layer 1a and is made of a different material from the first semiconductor layer 1a; the light-emitting layer 1c is between the first semiconductor layer 1a and the second semiconductor layer 1b and configured to emit light; the protection layer 3 is on a side of the first semiconductor layer 1a away from the second semiconductor layer 1b, the first semiconductor layer 1a includes a central region CA and an edge region PA around the central region CA, the protection layer 3 at least covers the central region CA, the central region CA includes a first action region 1A, when a needle is used to transfer the light-emitting device 10, the needle is located in the first action region 1A. The dashed circle in the central region of Fig. 1A represents the first action region 1A. Taking the case where the planar shape of the first action region is a circular shape as an example, for example, the planar shape of the first action region is also the planar shape of the contact surface between the needle and the light-emitting device. Of course, the planar shape of the first action region is not limited to the circular shape, and may be any shape.

During the process of using the needle of the transfer device to act on the central region CA on the front side of the light-emitting device 10 provided by the embodiments of the present disclosure to lift and transfer the light-emitting device 10, the needle is located on the side of the protection layer 3 away from the first semiconductor layer 1a, that is, the front side refers to the side where the protection layer 10 and the first semiconductor layer are located. Because the protection layer 3 is closer to the needle, and the protection layer 3 covers the central region CA and covers the first action region 1A where the needle is located when using the needle to transfer the light-emitting device 10, when the needle applies a force to the structure of the first action region 1A, the protection layer 3 can protect the layers below the structure which include the first semiconductor layer 1a, to prevent these layers from being damaged or ruptured by the needle, thereby preventing the current leakage problem of the light-emitting device caused by the rupture of these layers, and thus preventing the impact on the light-emitting efficiency of the light-emitting device, and preventing the problem of causing the bridge electrode to break and thus reducing signal transmission efficiency and other abnormal work problems.

It should be noted that the first action region refers to not only a region of the first semiconductor layer 1a, but also to a region suitable for a plurality of layers of the light-emitting device, that is, the plurality of layers all include portions located in the first action region, and the needle produces a force action on the portions located in the first action region of the plurality of layers.

For example, the light-emitting device 10 further includes a substrate 101, the first semiconductor layer 1a and the second semiconductor layer 1b are stacked on the main surface of the substrate 101. For example, the substrate 101 may be a sapphire substrate, a GaAs substrate, a GaN substrate, a SiC substrate, a Si substrate, may also by a glass substrate, a quartz substrate, etc. The embodiments of the present disclosure do not limit the material of the substrate, and those skilled in the art can choose according to needs.

The meaning of "cover" here is as follows. For example, the description "A covers B" refers to A being located on the side, close to the needle, of B, i.e. A is located on the side, away from the substrate 101, of B, and the orthographic projection of B on the horizontal plane is within the orthographic projection of A on the horizontal plane. For example, taking the direction in which the first semiconductor layer and the second semiconductor layer are stacked with each other as a vertical direction, the above horizontal plane is a plane perpendicular to the vertical direction, that is, the vertical direction is perpendicular to the main surface of the substrate 101, and the above horizontal plane is basically parallel to the main surface of the substrate 101.

For example, the light-emitting device 10 is a mini light-emitting diode (Mini LED) or a micro light-emitting diode (Micro LED). For example, the size of the mini light-emitting diode (Mini LED) ranges from approximately 100µm to 300µm. The size of the micro light-emitting diode (Micro LED) is less than 100µm. For example, the first semiconductor material is a P-type semiconductor material, and the second semiconductor material is an N-type semiconductor material, or, the first semiconductor material is an N-type semiconductor material, and the second semiconductor material is a P-type semiconductor material, electrons and holes combine in the light-emitting layer 1c under the drive of the current, and electrical energy is converted into light energy to emit light.

Referring to Figs. 1A-1B, for example, the protection layer 3 covers a portion of the upper surface of the first semiconductor layer 1a. For example, the first semiconductor layer 1a has an upper surface away from the second semiconductor layer 1b, and the area of the portion, covered by the protection layer 3, of the upper surface of the first semiconductor layer 1a accounts for no less than 1/2 of the area of the upper surface of the second semiconductor layer 1b, to reserve sufficient space for the action region 1A where the needle is located. The needle can act on the region within the orthographic projection of the protection layer 3 on the horizontal plane, thereby fully ensuring that the protection layer 3 covers the action region where the needle is located.

Referring to Figs. 1A-1B, for example, the light-emitting device 10 further includes: a first electrode 01, a second electrode 02, and a first insulation layer IL1. The first electrode 01 is electrically connected to the first semiconductor layer 1a through a first via V1 that penetrates the first insulation layer IL1; the second electrode 02 is electrically connected to the second semiconductor layer 1b through a second via V2 that penetrates the first insulation layer IL1. For example, the light-emitting device 10 further includes a first bridge electrode 4, the first bridge electrode 4 is located on the side of the first semiconductor layer 1a away from the second semiconductor layer 1b and is insulated from the second semiconductor layer 1b through an interlayer insulation layer IL0; the first electrode 01 is electrically connected to the first bridge electrode 4 through the first via V1, and the first bridge electrode 4 is electrically connected to the first semiconductor layer 1a. For example, the first bridge electrode 4 is directly in contact and connected with the surface of the first semiconductor layer 1a away from the substrate 101, so that the first electrode 01 is electrically connected to the first semiconductor layer 1a through the first bridge electrode 4.

For example, the first electrode 01 and the second electrode 02 are arranged in the transverse direction, and a longitudinal direction is perpendicular to the transverse direction. For example, in both transverse direction and longitudinal direction, the length of the portion, covered by the protection layer 3, of the first semiconductor layer 1a is greater than or equal to the length of the entire first semiconductor layer 1a, respectively, so as to further reserve a sufficient space for the action region 1A of the needle. The needle can act on the region within the orthographic projection of the protection layer 3 on the horizontal plane, thereby further ensuring that the protection layer 3 covers the action region where the needle is located.

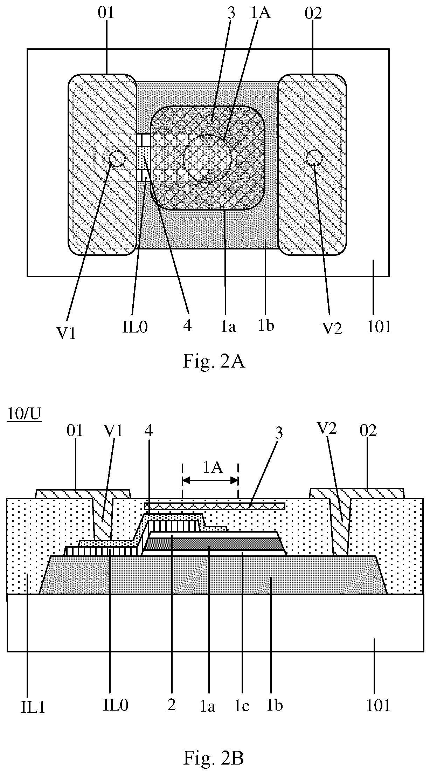

Fig. 2A is a schematic diagram of a planar structure of another light-emitting device provided by an embodiment of the present disclosure, and Fig. 2B is a schematic cross-sectional diagram of the light-emitting device in Fig. 2A. The difference between the light-emitting device shown in Figs. 2A-2B and the light-emitting device shown in Figs. 1A-1B is that, referring to Figs. 2A-2B, the protection layer 3 covers the entire first semiconductor layer 1a, that is, the orthographic projection of the first semiconductor layer 1a on the horizontal plane is located within the orthographic projection of the protection layer 3 on the horizontal plane, including the case where the area of the orthographic projection of the first semiconductor layer 1a on the horizontal plane is equal to the area of the orthographic projection of the protection layer 3 on the horizontal plane, and also includes the case where the area of the orthographic projection of the protection layer 3 on the horizontal plane is greater than the area of the orthographic projection of the first semiconductor layer 1a on the horizontal plane. The other structures and corresponding technical effects of the light-emitting device shown in Figs. 2A-2B are the same as those of the light-emitting device shown in Figs. 1A-1B, please refer to the descriptions of the light-emitting device shown in Figs. 1A-1B.

Continuing with reference to Figs. 1A-1B, the light-emitting device 10 further includes a current expansion layer 2, the current expansion layer 2 is stacked with the first semiconductor layer 1a and the second semiconductor layer 1b in the vertical direction, and located on the side of the first semiconductor layer 1a away from the second semiconductor layer 1b, and at least partially in contact with the first semiconductor layer 1a to be electrically connected to each other. The current expansion layer 2 includes a needle action portion located in the central region CA, the protection layer 3 at least covers the needle action portion of the current expansion layer 2 to protect the current expansion layer 2 from being damaged by the needle during the transfer process of the light-emitting device 10, thereby ensuring the normal conduction of electrical signals.

For example, the material of the current expansion layer 2 is a transparent conductive material that can transmit the light emitted by the light-emitting layer 1c. The transparent conductive material may be indium tin oxide (ITO), indium zinc oxide (IZO), zinc oxide, zinc alumina, gallium zinc oxide, etc., but is not limited to the types listed above. The embodiments of the present disclosure do not limit the type of the transparent conductive material.

For example, the protection layer 3 covers the entire current expansion layer 2, that is, the orthographic projection of the current expansion layer 2 on the horizontal plane is within the orthographic projection of the protection layer 3 on the horizontal plane, including the case where the area of the orthographic projection of the current expansion layer 2 on the horizontal plane is equal to the area of the orthographic projection of the protection layer 3 on the horizontal plane, and also includes the case where the area of the orthographic projection of the protection layer 3 on the horizontal plane is greater than the area of the orthographic projection of the current expansion layer 2 on the horizontal plane.

Referring to Figs. 1A-1B, for example, the protection layer 3 is floating, that is, the protection layer 3 is not connected to other conductive structures and does not transmit electrical signals. For example, the protection layer 3 may include a non-conductive material, or may include a conductive material. For example, the protection layer 3 is opaque.

For example, the protection layer 3 is a reflection layer that is floating, the reflection layer that is floating is separated from the first semiconductor layer 1a by the first insulation layer IL1 to insulate with each other. Light is emitted from the side where the substrate 101 is located, and the protection layer 3 is the reflection layer, which is beneficial for improving the reflectivity of light from the light-emitting layer 1c and enhancing the light-emitting rate of the light-emitting device 10. For example, the protection layer 3 is a metal layer that is floating, and the metal layer has a higher reflectivity. For example, the metal layer is a white metal layer to improve the light reflectivity as much as possible. For example, the material of the protection layer 3 is aluminum, which is lightweight and has a higher reflectivity, but the material of the protection layer is not limited to aluminum. Using a metal layer that is floating as the protection layer can not only protect the first semiconductor layer, the current expansion layer, and other layers from being damaged by the needle, but also improve the light output rate. Moreover, by floating the metal layer, it can avoid signal transmission in the metal layer and prevent the metal layer from interfering with the normal transmission of signals in the light-emitting device.

For example, referring to Fig. 1A, the central region CA of the first semiconductor layer 1a is located at the geometric center of the planar shape of the first semiconductor layer 1a, and the planar shape of the central region CA of the first semiconductor layer 1a basically coincides with the geometric center of the protection layer 3. For example, the planar shape of the first semiconductor layer 1a is the same as the planar shape of the protection layer 3. In this way, the structural symmetry can be better. The case where the planar shape of the first semiconductor layer 1a and the planar shape of the protection layer 3 are both rectangle shapes (right angled rectangles and rounded rectangles are collectively referred to as rectangle shape) is taken as an example. The geometric center of the rectangle shape is the intersection point of its diagonals. Of course, the planar shape of the first semiconductor layer 1a and the planar shape of the protection layer 3 can both be arbitrary shapes, which may be regular shapes such as circle shapes, ellipse shapes, polygon shapes, etc., or irregular shapes, and can be designed according to needs. In the case that the planar shape of the first semiconductor layer is an irregular shape, the protection layer basically covers the middle region of the first semiconductor layer.

Referring to Fig. 1B, for example, the first insulation layer IL1 wraps around the entire protection layer 3 that is floating, covers and contacts the lower surface, close to the first semiconductor layer 1a, of the protection layer 3 that is floating, the upper surface opposite to the lower surface, and the side surfaces intersecting both the upper surface of the protection layer 3 that is floating and the lower surface of the protection layer 3 that is floating to ensure insulation between the protection layer 3 that is floating and other structures.

For example, Figs. 1A-1B show the case of the light-emitting device having a single sub light-emitting unit. For example, in some embodiments, the light-emitting device may also include a plurality of sub light-emitting units. Fig. 1C is a schematic diagram of a light-emitting device including odd numbered sub light-emitting units provided by an embodiment of the present disclosure. Referring to Fig. 1C, for example, the light-emitting device 10 includes a plurality of sub light-emitting units, each sub light-emitting unit includes a first semiconductor layer 1a and a second semiconductor layer 1b which is stacked with the first semiconductor layer 1a and is made of a different material from the first semiconductor layer 1a, a plurality of sub light-emitting units that are continuously arranged constitute a light-emitting unit, the plurality of sub light-emitting units of the light-emitting unit include a sub light-emitting unit for transfer, the sub light-emitting unit for transfer also includes the above-mentioned protection layer, such as the protection layer 3. In one light-emitting unit, only the sub light-emitting unit for transfer includes the above-mentioned protection layer, while other sub light-emitting units other than the sub light-emitting unit for transfer do not include the above-mentioned protection layer, and when the light-emitting device is transferred using a needle, the needle acts on the sub light-emitting unit for transfer to transfer the plurality of sub light-emitting units together.

For example, odd numbered sub light-emitting units that are continuously arranged constitute a light-emitting unit. Referring to Fig. 1C, taking three sub light-emitting units that are continuously arranged as an example, a first sub light-emitting unit A, a second sub light-emitting unit B, and a third sub light-emitting unit C constitute a light-emitting unit. The sub light-emitting unit for transfer is located in the middle of the odd numbered sub light-emitting units, that is, the second sub light-emitting unit B in the middle serves as the sub light-emitting unit for transfer, to ensure the balance during the transfer process of the light-emitting device and improve the transfer yield of the light-emitting device.

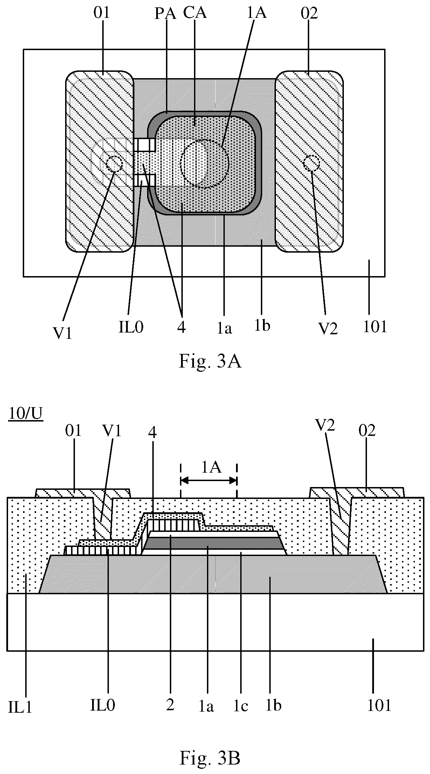

Fig. 3A is a schematic diagram of a planar structure of another light-emitting device provided by an embodiment of the present disclosure, and Fig. 3B is a schematic cross-sectional diagram of the light-emitting device in Fig. 3A. The light-emitting device shown in Figs. 3A-3B has the following difference from the light-emitting device shown in Figs. 1A-1B.

Referring to Figs. 3A-3B, for example, the light-emitting device 10 further includes a first bridge electrode 4, the first bridge electrode 4 is located on the side of the first semiconductor layer 1a away from the second semiconductor layer 1b, and is insulated from the second semiconductor layer 1b through an interlayer insulation layer IL0; the first electrode 01 is electrically connected to the first semiconductor layer 1a through the first bridge electrode 4; the second electrode 02 is electrically connected to the second semiconductor layer 1b, and the first bridge electrode 4 is further used as the protection layer. In this embodiment, the first bridge electrode 4 is used as the protection layer, which means that the first bridge electrode 4 at least covers the central region CA and the first action region 1A, for example, covers the entire first action region 1A, so that the layer in the region in contact with the needle can be protected. For example, the first bridge electrode 4 covers a portion of the upper surface of the first semiconductor layer 1a, for example, the area of the portion of the upper surface of the first semiconductor layer 1a covered by the first bridge electrode 4 accounts for no less than 1/2 of the area of the upper surface of the first semiconductor layer 1a; for example, the first bridge electrode 4 covers the entire first semiconductor layer 1a. Therefore, compared with the light-emitting device in Figs. 1A-1B, the area of the first bridge electrode 4 is increased, for example, the first bridge electrode 4 covers the first action region 1A, which can prevent the edge of the first bridge electrode 4 from being present in the first action region 1A where the needle is acted. Because of the high pressure brought by the needle at the edge of the first bridge electrode 4, the damage at the edge is more severe, and therefore in the process of using the needle to transfer the light-emitting device 10 shown in Fig. 3A, the needle acting on the first action region 1A will not cause significant damage to the first bridge electrode 4, thereby reducing the damage to the first bridge electrode 4 and the layers located below the first bridge electrode 4 during the transfer process of the light-emitting device 10, and for example, reducing the damage to the current expansion layer 2 and the first semiconductor layer 1a.

The first bridge electrode 4 is electrically connected to the first electrode 01 and the first semiconductor layer 1a of a single sub light-emitting unit. The second bridge electrode in the following is connected in series with adjacent sub light-emitting units.

The other structures and corresponding technical effects of the light-emitting device shown in Figs. 3A-3B are the same as those of the light-emitting device shown in Figs. 1A-1B, please refer to the descriptions of the light-emitting device shown in Figs. 1A-1B.

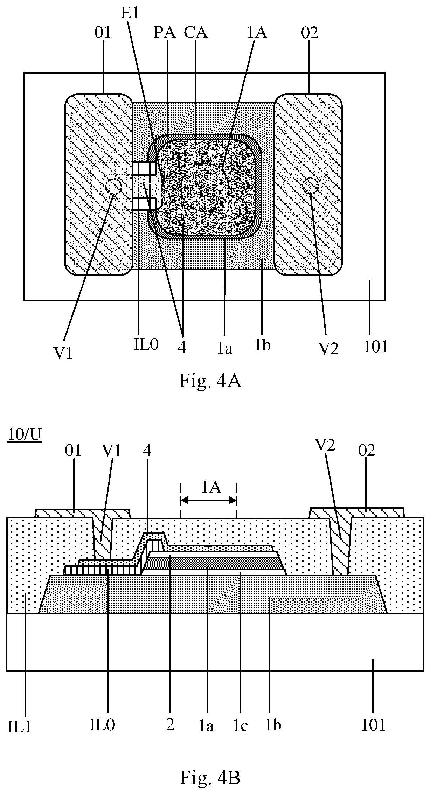

Fig. 4A is a schematic diagram of a planar structure of another light-emitting device provided by an embodiment of the present disclosure, and Fig. 4B is a schematic cross-sectional diagram of the light-emitting device in Fig. 4A. The light-emitting device shown in Figs. 4A-4B has the following difference from the light-emitting device shown in Figs. 1A-1B.

Referring to Figs. 4A-4B, for example, the interlayer insulation layer IL0 has an edge E1 close to the first action region 1A, and a portion of the first bridge electrode 4 covering the first action region 1A where the needle is acted does not cover the edge E1 of the interlayer insulation layer IL0 and has a flat surface, to eliminate the height difference between the first bridge electrode 4 and the interlayer insulation layer IL0 in the first action region 1A. If there is an edge E1 of the interlayer insulation layer IL0 in the first action region 1A, the first bridge electrode 4 covering the edge E1 of the interlayer insulation layer IL0 will form a height difference; when the needle acts on the first action region 1A, if the needle covers the position of the height difference and squeezes the position of the segment difference, it will cause excessive pressure at the position of the segment difference, resulting in severe damage to the top of the light-emitting device 10 at the position of the segment difference, especially the first bridge electrode 4 that is closer to the needle will be damaged heavily. If the first bridge electrode 4 breaks, it will cause poor electrical connection between the current expansion layer 2, the first semiconductor layer 1a and the first electrode 01, thereby affecting the light-emitting efficiency of the light-emitting device. By adopting the scheme shown in Figs. 4A-4B, it is possible to avoid the presence of the edge E1 of the interlayer insulation layer IL0 in the first action region 1A where the needle is acted, so that the first bridge electrode 4 will not cover the edge E1 of the interlayer insulation layer IL0, thereby avoiding the formation of segment difference in the first action region 1A where the needle is acted caused by the first bridge electrode 4 covering the edge E1 of the interlayer insulation layer IL0, in this way, when the needle acts on the first action region 1A, it will not squeeze the position of the segment difference, thereby avoiding significant damage to the first bridge electrode 4 at the position of the segment difference.

For example, in the embodiment shown in Figs. 4A-4B, a portion of the first semiconductor layer 1a is covered by the interlayer insulation layer IL0. For example, the length of the portion of the first semiconductor layer 1a covered by the interlayer insulation layer IL0 in the transverse direction is less than 1/4 of the length of the first semiconductor layer 1a in the transverse direction, to reserve a sufficient flat region for the first action region 1A (i.e., the region where there is no segment difference between the first bridge electrode 4 and the interlayer insulation layer IL0), it is easier to transfer the light-emitting device using the needle in the first action region 1A, ensuring the reliability of preventing damage to the top layer of the light-emitting device.

It should be noted that the "segment difference" in the present disclosure can be understood as a step structure, and this is also suitable for other embodiments, which will not be explained one by one.

The other structures and corresponding technical effects of the light-emitting device shown in Figs. 4A-4B are the same as those of the light-emitting device shown in Figs. 3A-3B, please refer to the descriptions of the light-emitting device shown in Figs. 3A-3B.

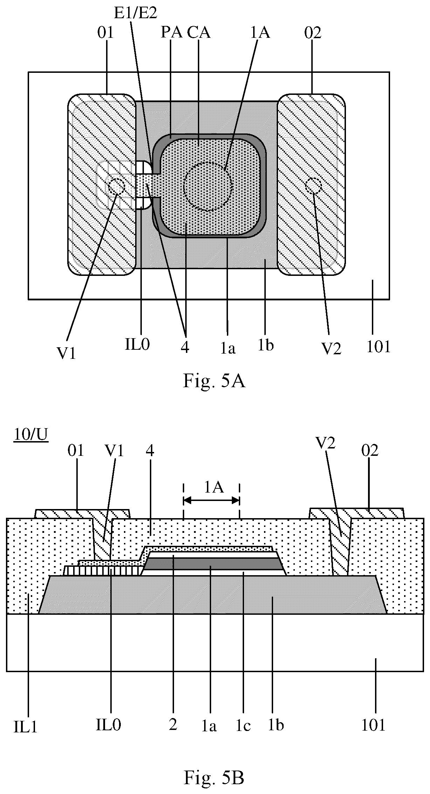

Fig. 5A is a schematic diagram of a planar structure of another light-emitting device provided by an embodiment of the present disclosure, and Fig. 5B is a schematic cross-sectional diagram of the light-emitting device in Fig. 5A. The light-emitting device shown in Figs. 5A-5B has the following difference from the light-emitting device shown in Figs. 3A-3B.

Referring to Figs. 5A-5B, for example, the portion of the first bridge electrode 4 covering the first action region 1A where the needle is acted does not cover the edge E1 of the interlayer insulation layer IL0 close to the first action region 1A and has a flat surface, to eliminate the segment difference between the first bridge electrode 4 and the interlayer insulation layer IL0 in the first action region 1A, and the entire first semiconductor layer 1a is not covered by the interlayer insulation layer IL0, that is, the first semiconductor layer 1a does not have a portion covered by the interlayer insulation layer IL0, and, in order to ensure that the interlayer insulation layer IL0 insulate the first bridge electrode 4 from the second semiconductor layer 1c, the edge E1 of the interlayer insulation layer IL0 close to the first action region 1A and the edge of the interlayer insulation layer IL0 close to the first semiconductor layer 1a are in contact with each other, and there is no gap between the two in the transverse direction, that is, the orthographic projection of the edge E1 of the interlayer insulation layer IL0 close to the first action region 1A on the horizontal plane coincides with the orthographic projection of the edge of the first semiconductor layer 1a close to the interlayer insulation layer IL0 on the horizontal plane, at least coincides in the range where the first bridge electrode 4 is distributed, and there is no gap between the orthographic projections of the two edges. In this way, a more sufficient flat region can be reserved for the first action region 1A, making it easier to transfer the light-emitting device using the needle in the first action region 1A, and more reliably preventing damage to the top layer of the light-emitting device.

The other structures and corresponding technical effects of the light-emitting device shown in Figs. 5A-5B are the same as those of the light-emitting device shown in Figs. 4A-4B, please refer to the descriptions of the light-emitting device shown in Figs. 4A-4B.

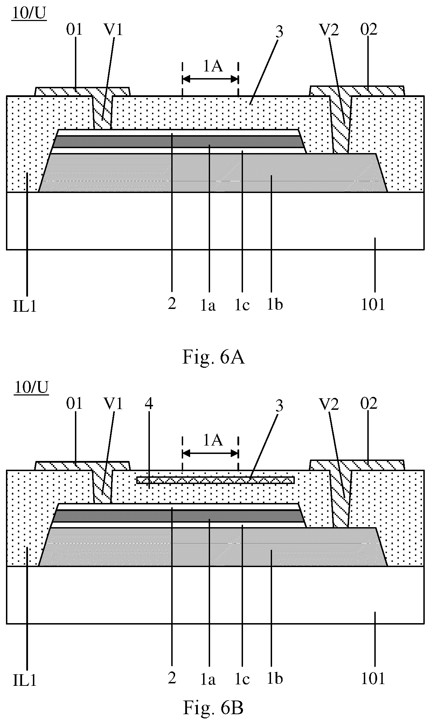

Fig. 6A is a schematic cross-sectional diagram of another light-emitting device provided by an embodiment of the present disclosure. The light-emitting device shown in Fig. 6A has the following difference from the light-emitting device shown in Figs. 1A-1B. Referring to Fig. 6A, the light-emitting device 10 includes a first electrode 01 and a second electrode 02. The first electrode 01 is electrically connected to the first semiconductor layer 1a; and the second electrode 02 is electrically connected to the second semiconductor layer 1b. The direction in which the first semiconductor layer 1a and the second semiconductor layer 1b are stacked with each other is a vertical direction, the orthographic projection of the first electrode 01 on the horizontal plane perpendicular to the vertical direction at least partially overlaps with the orthographic projection of the first semiconductor layer 1a on the horizontal plane, moreover, the first electrode 01 is directly electrically connected to the first semiconductor layer 1a through the first via V1, rather than being electrically connected through, for example, the first bridge electrode. For example, there is no other conductive structure between the first electrode 01 and the first semiconductor layer 1a, the first electrode 01 and the first semiconductor layer 1a are electrically connected without any other structure, such as the first bridge electrode, thereby removing the first bridge electrode and the interlayer insulation layer used to insulate the first bridge electrode from the second semiconductor layer, simplifying the structure of the light-emitting device 10, and thus forming a flat structure on the surface of the first semiconductor layer 1a away from the second semiconductor layer 1b (i.e. above the first semiconductor layer 1a), which allows the needle to act on the flat structure, thereby reducing the damage caused by the needle to the flat structure above the first semiconductor layer 1a and the first semiconductor layer 1a.

For example, referring to Fig. 6A, the light-emitting device 10 includes a current expansion layer 2, the current expansion layer 2 is stacked with the first semiconductor layer 1a and the second semiconductor layer 1b, and located on the side of the first semiconductor layer 1a away from the second semiconductor layer 1b, and at least partially in contact with the first semiconductor layer 1a to be electrically connected to each other. The current expansion layer 2 includes a needle action portion located in the central region CA. For example, as shown in Fig. 6A, the first electrode 01 is in contact with the current expansion layer 2 through the first via V1 to be electrically connected to the current expansion layer 2. For example, the surface of the current expansion layer 2 away from the first semiconductor layer 1a is a flat surface. In this embodiment, the first bridge electrode and the interlayer insulation layer used to insulate the first bridge electrode from the second semiconductor layer are removed, thereby removing the segment difference formed by the insulation between the first bridge electrode and the second semiconductor layer that exists above the current expansion layer 2. For example, the current expansion layer 2 is also used as the protection layer covering the first action region 1A where the needle is acted of the first semiconductor layer 1a. For example, the current expansion layer 2 covers the entire first action region 1A where the needle is acted to ensure that the entire region in contact with the needle is flat. For example, the current expansion layer 2 covers a portion of the upper surface of the first semiconductor layer 1a, for example, the area of the portion of the upper surface of the first semiconductor layer 1a covered by the current expansion layer 2 accounts for no less than 1/2 of the area of the upper surface of the first semiconductor layer 1a; for example, the current expansion layer 2 covers the entire first semiconductor layer 1a. Because the surface of the current expansion layer 2 away from the first semiconductor layer 1a is a flat surface, there is no edge of a certain layer that can form a segment difference between layers within the first action region 1A where the needle is acted, because of the significant pressure caused by the needle at the edge of a certain layer within the first action region, the damage at the edge is more severe. Therefore, during the process of transferring the light-emitting device 10 shown in Fig. 3A using the needle, the needle acting on the first action region 1A will not cause significant damage to the current expansion layer 2, thus, the flat current expansion layer 2 is utilized to weaken the damage to the current expansion layer 2 itself and the first semiconductor layer 1a covered by the current expansion layer 2 during the transfer process of the light-emitting device 10.

Fig. 6B is a schematic cross-sectional diagram of another light-emitting device provided by an embodiment of the present disclosure. The light-emitting device shown in Fig. 6B has the following difference from the light-emitting device shown in Fig. 6A. Referring to Fig. 6B, similar to the scheme shown in Figs. 1A-1B, the light-emitting device 10 includes an additional protection layer that is floating as the protection layer 3. The protection layer 3 at least covers a needle action portion of the current expansion layer 2 to further utilize the protection layer 3 to prevent damage of the needle to the current expansion layer 2 and the first semiconductor layer 1a. The other structures in Fig. 6B are the same as the corresponding structures in Fig. 6A, and can be referred to the descriptions of Fig. 6A. In addition, for other structures not introduced in Figs. 6A and 6B, such as the substrate, the light-emitting layer, etc., please refer to the corresponding features in other embodiments mentioned above, which will not be repeated here.

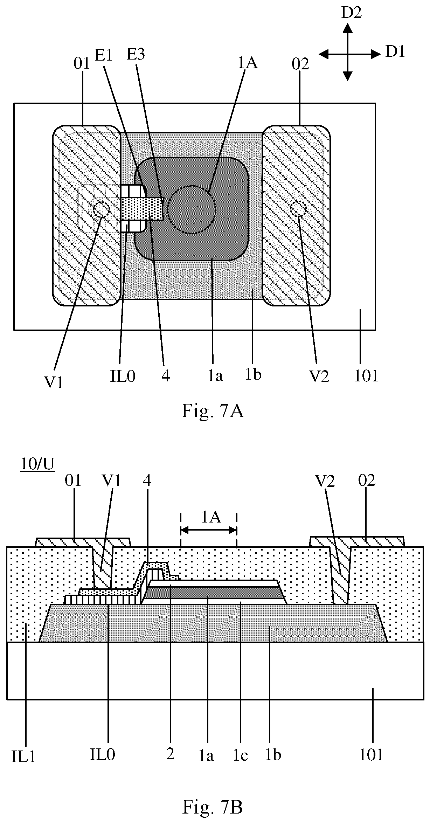

Fig. 7A is a schematic diagram of a planar structure of another light-emitting device provided by an embodiment of the present disclosure, and Fig. 7B is a schematic cross-sectional diagram of the light-emitting device in Fig. 7A. The light-emitting device shown in Figs. 7A-7B has the following difference from the light-emitting device shown in Figs. 1A-1B.

Referring to Figs. 7A-7B, for example, the direction in which the first semiconductor layer 1a and the second semiconductor layer 1b are stacked with each other is the vertical direction, and the orthographic projection of the first bridge electrode 4 on a horizontal plane perpendicular to the vertical direction overlaps with a part of the orthographic projection of the first semiconductor layer 1a on the horizontal plane, and does not overlap with the orthographic projection of the first action region 1A where the needle is acted in the central region on the horizontal plane. Because when the needle is used to transfer the light-emitting device 10, the needle is located in the first action region 1A, the technical solution in Figs. 7A-7B can enable the first bridge electrode 4 to avoid the first action region 1A where the needle is acted, and the edge E3, close to the first action region 1A, of the first bridge electrode 4 does not exist in the first action region 1A, thereby preventing damage to the first bridge electrode 4 caused by the needle and preventing the segment difference formed by the edge E3 of the first bridge electrode 4 being in the first action region 1A, and preventing the risk of significant damage to the layer at the position of the segment difference caused by the needle and improving the transfer yield of the light-emitting device.

Referring to Fig. 7A, for example, the orthographic projection of the first bridge electrode 4 extends along the transverse direction D1 towards the orthographic projection of the first semiconductor layer 1a to overlap with the orthographic projection of the first semiconductor layer 1a. The width of the overlapping portion of the orthographic projection of the first bridge electrode 4 and the orthographic projection of the first semiconductor layer 1a in the transverse direction D1 is less than half of the width of the first semiconductor layer 1a in the transverse direction D1, to ensure that the first bridge electrode 4 avoids the first action region 1A where the needle is acted.

Referring to Fig. 7A, for example, the edge E3, close to the first action region 1A, of the orthographic projection of the first bridge electrode 4 on the horizontal plane includes a concave portion depressed in a direction away from the first action region 1A. Due to the existence of this concave portion, the needle is not easily pressed against the edge E3 of the first bridge electrode 4, thereby reducing the risk that the edge E3 of the first bridge electrode 4 contacts the needle, so that the edge E3 of the first bridge electrode 4 avoids the needle during the action of the needle.

Referring to Fig. 7A, for example, the shapes of the outer contours of, the edge of the orthographic projection of the first bridge electrode 4 on the horizontal plane and the edge of the orthographic projection of the needle located in the first action region 1A on the horizontal plane that are opposite to each other, are complementary, that is, the shape of the concave portion of the edge E3 of the first bridge electrode 4 and the edge, opposite to the concave portion, of the first action region 1A are complementary, to make the edge E3 of the first bridge electrode 4 more effectively avoid the needle.

Referring to Fig. 7A, for example, the shape of the concave portion of the edge E3 of the orthographic projection of the first bridge electrode 4 on the horizontal plane is an arc shape depressed in a direction away from the first action region. For example, the orthographic projection of the edge E3 of the first action region 1A on the horizontal plane is a circular arc. For example, the outer contour of the orthographic projection of the needle on the horizontal plane is circular. The curvature of the circular arc of the edge E3 of the first action region 1A where the needle is acted is basically the same as the curvature of the circular arc portion opposite to the outer contour of the needle, to make the edge E3 of the first bridge electrode 4 more effectively avoid the needle.

Referring to Fig. 7A, for example, the interlayer insulation layer IL0 has an edge E1 close to the first action region 1A, in the transverse direction D1, the edge E1 of the interlayer insulation layer IL0 is located on the side of the edge E3 of the first bridge electrode 4 away from the first action region 1A, to avoid a segment difference formed between the interlayer insulation layer IL0 and the first bridge electrode 4 and at the position close to the central region. For example, in Fig. 7A, a portion of the first semiconductor layer 1a is covered by the interlayer insulation layer IL0. In other embodiments, the position of the interlayer insulation layer IL0 can also be similar to the situation shown in Fig. 5A, and the edge E1 of the interlayer insulation layer IL0 close to the first action region 1A and the edge of the interlayer insulation layer IL0 close to the first semiconductor layer 1a are in contact with each other, and no gap is between the two in the transverse direction, that is, the orthographic projection of the edge E1 of the interlayer insulation layer IL0 close to the first action region 1A on the horizontal plane coincides with the orthographic projection of the edge of the first semiconductor layer 1a close to the interlayer insulation layer IL0 on the horizontal plane, coincides at least in the range where the first bridge electrode 4 is distributed, and no gap is between the orthographic projections of the two edges.

For example, the light-emitting device shown in Fig. 7A does not include the protection layer 3.

The other structures and corresponding technical effects of the light-emitting device shown in Figs. 7A-7B are the same as those of the light-emitting device shown in Figs. 1A-1B, please refer to the descriptions of the light-emitting device shown in Figs. 1A-1B.

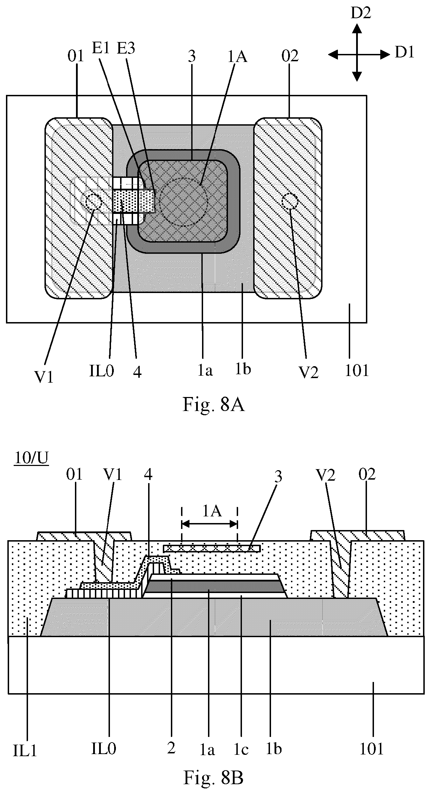

For example, Fig. 8A is a schematic diagram of a planar structure of another light-emitting device provided by an embodiment of the present disclosure, and Fig. 8B is a schematic cross-sectional diagram of the light-emitting device in Fig. 8A. The difference between the light-emitting device shown in Figs. 8A-8B and the light-emitting device shown in Figs. 7A-7B is that, with reference to Figs. 8A-8B, for example, the light-emitting device 10 may include the above-mentioned protection layer 3, the protection layer 3 is floating to further enhance the protection of the current expansion layer 2 and the first semiconductor layer 1a.

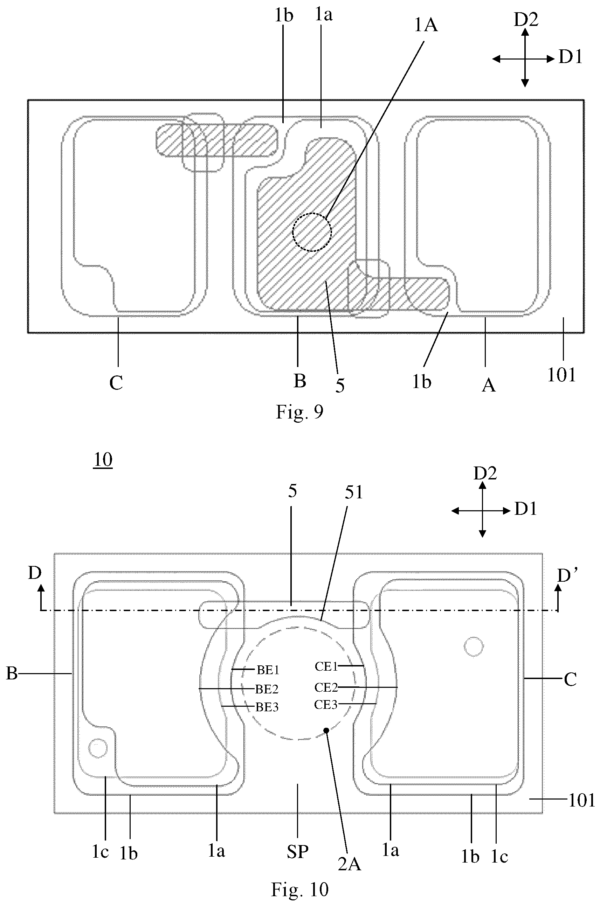

Fig. 9 is a schematic diagram of a planar structure of another light-emitting device provided by an embodiment of the present disclosure. Referring to Fig. 9, for example, one light-emitting unit of the light-emitting device includes a plurality of sub light-emitting units, the plurality of sub light-emitting units include a sub light-emitting unit for transfer B and a first sub light-emitting unit A adjacent to the sub light-emitting unit for transfer B; similar to Fig. 1C, one light-emitting unit including odd numbered (e.g. 3) sub light-emitting units that are continuously arranged is taken as an example, a first sub light-emitting unit A, a second sub light-emitting unit B, and a third sub light-emitting unit C constitute a light-emitting unit, and the sub light-emitting unit for transfer is located in the middle of the odd numbered sub light-emitting units, that is, the second sub light-emitting unit B located in the middle serves as the sub light-emitting unit for transfer. The first sub light-emitting unit A is adjacent to the sub light-emitting unit for transfer B. The light-emitting device 10 further includes a second bridge electrode 5, the second bridge electrode 5 electrically connects the first semiconductor layer 1a of the sub light-emitting unit for transfer B and the second semiconductor layer 1b of the first sub light-emitting unit A. For example, the second bridge electrode 5 is also used as the above protection layer, that is, the second bridge electrode 5 at least covers the central region CA and the first action region 1A of the sub light-emitting unit for transfer B. For example, the second bridge electrode 5 covers the entire first action region 1A to ensure that all the layers in the region in contact with the needle can be protected by the second bridge electrode 5. For example, the second bridge electrode 5 covers a portion of the upper surface of the first semiconductor layer 1a, or, in other embodiments, the area of the upper surface of the first semiconductor layer 1a covered by the second bridge electrode 5 accounts for no less than 1/2 of the area of the upper surface of the first semiconductor layer 1a; and for example, the second bridge electrode 5 covers the entire first semiconductor layer 1a. As a result, compared with ordinary light-emitting device, the area of the second bridge electrode 5 is increased, for example, by covering the first action region 1A with the second bridge electrode 5, the edge of the second bridge electrode 5 does not exist in the first action region 1A where the needle is acted. Due to the high pressure brought by the needle at the edge of the second bridge electrode, the damage at the edge is more severe. Therefore, in the process of using the needle to transfer the light-emitting device 10 shown in Fig. 9, the needle acting on the first action region 1A will not cause significant damage to the second bridge electrode 5, so as to weaken the damage to the second bridge electrode 5 and the damage to the layers located below the second bridge electrode 5 during the transfer process of the light-emitting device 10, for example, weaken the damage to the current expansion layer 2 and the first semiconductor layer 1a.

For example, in the light-emitting device shown in Fig. 9, the upper surface of the second bridge electrode 5 away from the first semiconductor layer 1a is a flat surface, that is, there is no segment difference formed between the second bridge electrode 5 and other layers on the upper surface of the second bridge electrode 5, to ensure that this segment difference does not exist in the first action region 1A, and to avoid excessive pressure caused by the needle on the layers at the position of the segment difference, so as to avoid the problem of severe damage to the top of the light-emitting device 10 at the position of the segment difference.

For example, for the light-emitting device shown in Fig. 9, the sub light-emitting unit for transfer B may include the above-mentioned additional protection layer, similar to the protection layer 3 that is floating in Figs. 1A-1B, or may not include the additional protection layer that is floating.

Other unmentioned structures of each sub light-emitting unit in Fig. 9, can be referred to the previous descriptions.

Fig. 10 is a schematic diagram of a planar structure of a light-emitting device including even numbered sub light-emitting units provided by an embodiment of the present disclosure. Referring to Fig. 10, for example, the light-emitting device 10 includes a plurality of sub light-emitting units, each sub light-emitting unit includes a first semiconductor layer 1a and a second semiconductor layer 1b which is stacked with the first semiconductor layer 1a and is made of a different material from the first semiconductor layer 1a. A plurality of sub light-emitting units that are continuously arranged constitute one light-emitting unit.

For example, even numbered sub light-emitting units that are continuously arranged constitute a light-emitting unit. Referring to Fig. 10, taking two sub light-emitting units that are continuously arranged as an example, the second sub light-emitting unit B and the third sub light-emitting unit C that are adjacent constitute one light-emitting unit. A gap SP is between the second sub light-emitting unit B and the third sub light-emitting unit C. The second action region 2A where the needle is acted is located within the gap SP, and the surface of the gap SP away from the substrate 101 is flat, that is, the surface of the gap SP in contact with the second action region 2A is flat, which refers to no segment difference or step, formed by the edge of a layer, formed on the surface of the gap SP in contact with the second action region 2A. When using a needle to transfer the light-emitting device 10, the needle is located in the second action region 2A, and the needle acts on the second action region 2A to transfer the plurality of sub light-emitting units together. The light-emitting device 10 further includes a second bridge electrode 5, and the second bridge electrode 5 electrically connects the first semiconductor layer 1a of the second light-emitting unit B and the second semiconductor layer 1b of the third sub light-emitting unit C. The direction in which the first semiconductor layer 1a and the second semiconductor layer 1b are stacked with each other is a vertical direction, and the orthographic projection of the second bridge electrode 5 on a horizontal plane perpendicular to the vertical direction does not overlap with the orthographic projection of the second action region 2A where the needle is acted on the horizontal plane, so that the second bridge electrode 5 avoids the second action region 2A where the needle is acted, and there is also no edge of the second bridge electrode 5 in the second action region 2A, the needle acts on the flat gap SP, thereby avoiding damage to the second bridge electrode 5 caused by the needle, and also avoiding the segment difference formed by the edge of the second bridge electrode 5 in the second action region 2A, avoiding the risk of significant damage to the layers at the position of the segment difference caused by the needle, and improving the transfer yield of the light-emitting device.

Referring to Fig. 10, for example, the second light-emitting unit B and the third sub light-emitting unit C are arranged in the transverse direction D1, and the direction perpendicular to the transverse direction D1 on the extending plane of the second semiconductor layer 1b is the longitudinal direction D2; the second bridge electrode 5 extends in the transverse direction D1 and is located on a side of the second action region 2A in the longitudinal direction D2. In the longitudinal direction D2, the second action region 2A is located in the middle region of the gap SP, that is, in the longitudinal direction D2, the distance from the center of the second action region 2A to the upper edge of the second light-emitting unit B is basically equal to the distance from the center of the second action region 2A to the lower edge of the second light-emitting unit B. The upper edge of the second light-emitting unit B is opposite to the lower edge of the second light-emitting unit B in the longitudinal direction D2. For example, the upper edge of the third sub light-emitting unit C is basically flush with the upper edge of the second light-emitting unit B, and the lower edge of the third sub light-emitting unit C is basically flush with the lower edge of the second light-emitting unit B; in the transverse direction D1, the second action region 2A is also located in the middle region of the gap SP, that is, in the transverse direction D1, the distance from the center of the second action region 2A to the edge of the second light-emitting unit B closest to the third sub light-emitting unit C is basically equal to the distance from the center of the second action region 2A to the edge of the third light-emitting unit C closest to the second light-emitting unit B. The upper edge of the second light-emitting unit B is opposite to the lower edge of the second light-emitting unit B in the longitudinal direction D2. In this way, the second bridge electrode 5 can avoid the second action region 2A to maintain the needle and avoid damage to the second bridge electrode 5, while also maintaining the needle acting on the middle region of the gap SP to ensure the balance of the light-emitting device in the transfer process and improve the transfer yield of the light-emitting device.

For example, the center of the second action region 2A refers to the geometric center of the planar shape of the second action region 2A; the region where the contact surface between the needle and the light-emitting device is located is the second action region 2A. Fig. 10 takes the second action region 2A is in a circular shape as an example, with the center of the second action region 2A as the center of the circular shape. Of course, it can also be other regular shapes, such as a polygon shape, an ellipse shape, etc.

Referring to Fig. 10, for example, the edge 51 (hereinafter referred to as the edge 51 of the second bridge electrode 5) of the orthographic projection of the second bridge electrode 5 on the horizontal plane close to the second action region 2A includes a concave portion depressed in a direction away from the second action region 2A. Due to the existence of the concave portion, the needle is not easily pressed against the edge 51 of the second bridge electrode 5, thereby reducing the risk of the edge 51 of the second bridge electrode 5 contacting the needle, and making the edge 51 of the second bridge electrode 5 avoid the needle during the action of the needle.

Referring to Fig. 10, for example, the shapes of, the edge of the orthographic projection of the second bridge electrode 5 on the horizontal plane and the edge of the orthographic projection of the needle located in the second action region 2A on the horizontal plane that are opposite to each other, are complementary, and the shape of the concave portion of the edge 51 of the second bridge electrode 5 is complementary to the shape of the edge, opposite to the second bridge electrode 5, of the orthographic projection of the second action region 2A on the horizontal plane, to make the second bridge electrode 5 more effectively avoid the needle.

Referring to Fig. 10, for example, the first edge BE1 of the second semiconductor layer 1b of the second sub light-emitting unit B close to of the third sub light-emitting unit C in the transverse direction D1 is closer to the gap SP than the first edge BE2 of the first semiconductor layer 1a of the second sub light-emitting unit B close to the third sub light-emitting unit C in the transverse direction D1, and the first edge CE1 of the second semiconductor layer 1b of the third sub light-emitting unit C close to the second sub light-emitting unit B in the transverse direction D1 is closer to the gap SP than the first edge CE2 of the first semiconductor layer 1a of the third sub light-emitting unit C close to the second sub light-emitting unit B in the transverse direction D1; the first edge BE1 of the second semiconductor layer 1b of the second sub light-emitting unit B includes a concave portion depressed in a direction away from the third sub light-emitting unit C, and the first edge CE1 of the second semiconductor layer 1b of the third sub light-emitting unit C includes a concave portion depressed in a direction away from the second sub light-emitting unit B. Due to the presence of the above concave portion, the needle is not easily pressed onto the first edge BE1 of the second semiconductor layer 1b of the second sub light-emitting unit B and the first edge CE1 of the second semiconductor layer 1b of the third sub light-emitting unit C, thereby reducing the risk of contact between the needle and the first edge BE1 of the second semiconductor layer 1b of the second sub light-emitting unit B and the risk of contact between the needle and the first edge CE1 of the second semiconductor layer 1b of the third sub light-emitting unit C, making the entire second semiconductor layer 1b of the second sub light-emitting unit B and the entire second semiconductor layer 1b of the third sub light-emitting unit C avoid the needle during the action of the needle.

Referring to Fig. 10, for example, the shape of the concave portion of the first edge BE1 of the second semiconductor layer 1b of the second sub light-emitting unit B is complementary to the shape of the concave portion of the first edge CE1 of the second semiconductor layer 1b of the third sub light-emitting unit C, thereby making the second semiconductor layer 1b of the second sub light-emitting unit B and the second semiconductor layer 1b of the third sub light-emitting unit C more effectively avoid the needle.

Referring to Fig. 10, for example, the edge of the orthographic projection of the first semiconductor layer 1a of the second sub light-emitting unit B on the horizontal plane and the edge of the orthographic projection of the first semiconductor layer 1a of the third sub light-emitting unit C on the horizontal plane that are opposite to each other respectively include a concave portion depressed in a direction away from the gap SP, that is, the edge BE3 of the first semiconductor layer 1a of the second sub light-emitting unit B close to the third sub light-emitting unit C includes a concave portion depressed in a direction away from the third sub light-emitting unit C, and the edge CE3 of the first semiconductor layer 1a of the third sub light-emitting unit C close to the second sub light-emitting unit B includes a concave portion depressed in a direction away from the second sub light-emitting unit B.

Referring to Fig. 10, for example, the edge of the orthographic projection of the light-emitting layer 1c of the second sub light-emitting unit B on the horizontal plane and the edge of the orthographic projection of the light-emitting layer 1c of the third sub light-emitting unit C on the horizontal plane that are opposite to each other respectively include a concave portion depressed in a direction away from the gap SP, so that the light-emitting layer 1c of the second sub light-emitting unit B and the light-emitting layer 1c of the third sub light-emitting unit C can more effectively avoid the second action region 2A of the needle.

For example, for the light-emitting device shown in Fig. 10, each sub light-emitting unit may include a first action region of the needle. For each sub light-emitting unit, a corresponding protection layer that is floating may be provided (similar to the protection layer 3 that is floating in Figs. 1A-1B), to provide each sub light-emitting unit with the first action region in which the needle acts on the central region, so as to prepare for the transfer of the plurality of sub light-emitting units, which expands the transfer modes of the light-emitting device. For example, the light-emitting device shown in Fig. 10 may not have the protection layer that is floating.

For example, for the light-emitting device shown in Fig. 10, the second sub light-emitting unit B may include a first action region where the needle is acted, to provide each sub light-emitting unit with the first action region in which the needle acts on the central region, so as to prepare for the transfer of the plurality of sub light-emitting units, which expands the transfer modes of the light-emitting device. For the second sub light-emitting unit B, a corresponding protection layer may be provided and the area of the second bridge electrode 5 may be increased to make the second bridge electrode 5 cover the central region of the first semiconductor layer 1a of the second sub light-emitting unit B, so that the second bridge electrode 5 covers the first action region of the needle of the second sub light-emitting unit B, that is, the second bridge electrode 5 is also used as the protection layer, similar to the use of the first bridge electrode 4 as the protection layer in Fig. 4A, to prevent damage to the layer of the light-emitting device by the needle. Similarly, the same applies to the third light-emitting unit C. In this case, the second bridge electrode 5 may have features related to the first bridge electrode in the previous embodiment of using the first bridge electrode as the protection layer (for example, the edge shape is complementary with the shape of the outer contour of the corresponding first action region), these features can be combined with the using of the second bridge electrode 5 as the protection layer in Fig. 10.

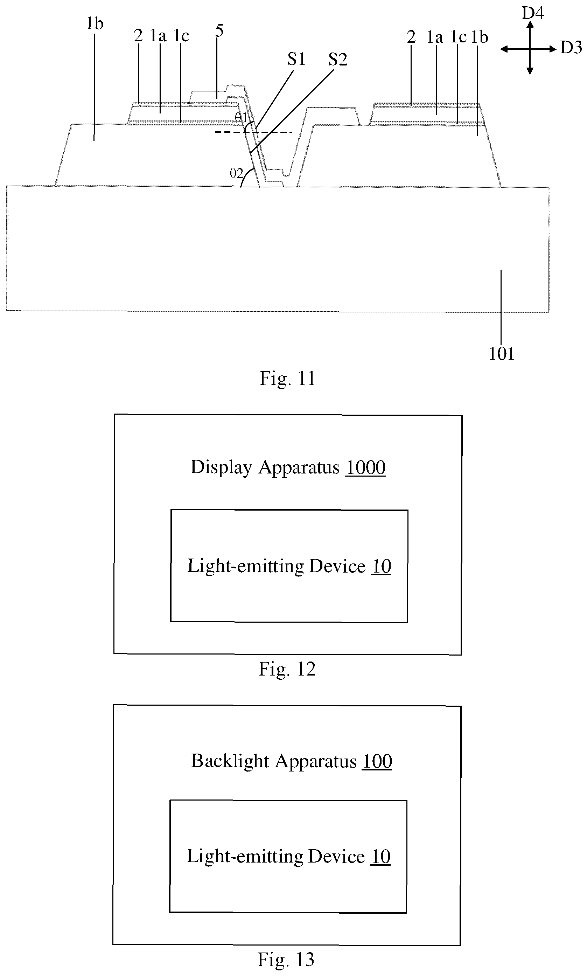

Fig. 11 is a schematic cross-sectional diagram along a line D-D' in Fig. 10. Referring to Fig. 11, the direction in which the first semiconductor layer 1a and the second semiconductor layer 1b are stacked with each other is the vertical direction D4, and the horizontal direction D3 is perpendicular to the vertical direction D4. For example, the cross-section of the second bridge electrode 5 along the vertical direction D4 includes a first slope surface S1, and an included angle (hereinafter referred to as the first angle) between the first slope surface S1 and the horizontal direction D3 is less than or equal to 70°. The smaller the first angle, the more conducive it is to maintaining the stability of the layer of the second bridge electrode 5, which is conducive to the stability of the coverage of the second bridge electrode 5 for the layers below the second bridge electrode 5, and is conducive to the stability of the entire light-emitting device structure. After testing, it was found that when the first angle is less than or equal to 70°, the ideal film stability of the second bridge electrode 5 can be achieved, and when the first angle is greater than 70°, the second bridge electrode 5 is prone to detachment, resulting in poor film stability.

Referring to Fig. 11, for example, the cross-section of the second semiconductor layer 1b along the vertical direction D4 includes a second sloping surface S2, and an included angle (hereinafter referred to as the second angle) between the second sloping surface S2 and the horizontal direction is less than or equal to 70°. The smaller the second angle, the more conducive it is to maintaining the stability of the layer covering the second sloping surface S2 of the second semiconductor layer 1b, thereby facilitating the stability of the entire light-emitting device structure. After testing, it was found that in the case where the second angle is less than or equal to 70°, the ideal film stability can be achieved, and in the case where the second angle is greater than 70°, the layer covering the second sloping surface S2 of the second semiconductor layer 1b is prone to detachment, resulting in poor film stability.

At least one embodiment of the present disclosure also provides a display apparatus, and Fig. 12 is a schematic diagram of an electronic apparatus provided by one embodiment of the present disclosure. Referring to Fig. 12, the display apparatus 1000 provided by the embodiments of the present disclosure includes any one of the light-emitting devices 10 provided by the embodiments of the present disclosure. For example, the display apparatus 1000 includes a light-emitting array, which includes a plurality of light-emitting devices 10 arranged in an array. For example, the display apparatus may be any product or component with a display function, such as a monitor, a display panel, a TV, an e-paper, a mobile phone, a tablet, a laptop, a digital photo frame, a navigation device, etc. Of course, the display apparatus is not limited to the types listed above.

At least one embodiment of the present disclosure further provides a backlight apparatus. Fig. 13 is a schematic diagram of a backlight apparatus provided by an embodiment of the present disclosure, referring to Fig. 13. the backlight apparatus 100 provided by the embodiments of the present disclosure includes any one of the light-emitting devices 10 provided by embodiments of the present disclosure. The backlight apparatus 100 can serve as a backlight source for any electronic apparatus that requires backlight. For example, the backlight apparatus 100 includes a light-emitting array, which includes a plurality of light-emitting devices 10 arranged in an array.

At least one embodiment of the present disclosure further provides an electronic apparatus which includes any one of the backlight apparatus 100 provided by the embodiments of the present disclosure.

For example, the electronic apparatus may be a display apparatus, the backlight apparatus 100 serves as the backlight source for the display apparatus; the display apparatus may be, for example, a liquid crystal display apparatus, or any other display apparatus that requires a backlight source. For example, the display apparatus may be any product or component with a display function, such as a monitor, a display panel, a TV, an e-paper, a mobile phone, a tablet, a laptop, a digital photo frame, a navigation device, etc. Of course, the display apparatus is not limited to the types listed above.

For example, the electronic apparatus may be a lighting device, such as a lamp, and the backlight apparatus 100 serves as the backlight source for the lighting device, and providing a light source for the lighting device.

What have been described above are only specific implementations of the present disclosure, the protection scope of the present disclosure is not limited thereto, and the protection scope of the present disclosure should be based on the protection scope of the claims.

## Claims

1. A light-emitting device, comprising a sub light-emitting unit, wherein the sub light-emitting unit comprises:
a first semiconductor layer;
a second semiconductor layer, stacked with the first semiconductor layer and being made of a different material from the first semiconductor layer;
a light-emitting layer, between the first semiconductor layer and the second semiconductor layer;
a protection layer, on a side of the first semiconductor layer away from the second semiconductor layer, wherein the first semiconductor layer comprises a central region and an edge region around the central region, the protection layer at least covers the central region, and the central region comprises a first action region, upon a needle being used to transfer the light-emitting device, the needle is located in the first action region.

2. The light-emitting device according to claim 1, wherein the first semiconductor layer has an upper surface away from the second semiconductor layer, and an area of a portion of the upper surface of the first semiconductor layer covered by the protection layer accounts for no less than 1/2 of an area of an upper surface of the second semiconductor layer.

3. The light-emitting device according to claim 1, wherein the protection layer covers an entirety of the first semiconductor layer.

4. The light-emitting device according to claim 1, further comprising:
a current expansion layer, stacked with the first semiconductor layer and the second semiconductor layer, on the side of the first semiconductor layer away from the second semiconductor layer, and at least partially in contact with the first semiconductor layer to be electrically connected to each other, wherein the current expansion layer comprises a needle action portion in the central region, and the protection layer at least covers the needle action portion of the current expansion layer.

5. The light-emitting device according to claim 4, wherein the protection layer covers an entirety of the current expansion layer.

6. The light-emitting device according to any one of claims 1-5, further comprising a first insulation layer, wherein the protection layer is floating, and the protection layer that is floating and the first semiconductor layer are separated by the first insulation layer to insulate with each other.

7. The light-emitting device according to claim 6, wherein the first insulation layer wraps around an entirety of the protection layer that is floating, covers and contacts a lower surface of a reflection layer that is floating close to the first semiconductor layer, an upper surface opposite to the lower surface, and a side surface intersecting both the upper surface of the reflection layer that is floating and the lower surface of the reflection layer that is floating.

8. The light-emitting device according to any one of claims 1-5, further comprising:
a first bridge electrode, on the side of the first semiconductor layer away from the second semiconductor layer, and insulated from the second semiconductor layer through an interlayer insulation layer;
a first electrode, electrically connected to the first semiconductor layer through the first bridge electrode; and
a second electrode, electrically connected to the second semiconductor layer,
wherein the first bridge electrode is further used as the protection layer, and no edge of the first bridge electrode is within the first action region where the needle is located.

9. The light-emitting device according to claim 8, wherein a portion of the first bridge electrode that covers the first action region where the needle is located does not cover an edge of the interlayer insulation layer and has a flat surface.

10. The light-emitting device according to any one of claims 1-3, further comprising:
a first electrode, electrically connected to the first semiconductor layer; and
a second electrode, electrically connected to the second semiconductor layer, wherein a direction in which the first semiconductor layer and the second semiconductor layer are stacked with each other is a vertical direction, an orthographic projection of the first electrode on a horizontal plane perpendicular to the vertical direction at least partially overlaps with an orthographic projection of the first semiconductor layer on the horizontal plane, and the first electrode is directly electrically connected to the first semiconductor layer through a via;
the light-emitting device further comprises a current expansion layer, the current expansion layer is stacked with the first semiconductor layer and the second semiconductor layer, is on the side of the first semiconductor layer away from the second semiconductor layer, and is at least partially in contact with the first semiconductor layer to be electrically connected to each other, the current expansion layer comprises a needle action portion in the central region;
a surface of the current expansion layer away from the first semiconductor layer is a flat surface, and the current expansion layer is further used as the protection layer, or, the light-emitting device further comprises a first insulation layer, the protection layer is a reflection layer that is floating, and the reflection layer that is floating and the first semiconductor layer are separated by the first insulation layer to insulate with each other, the protection layer at least covers the needle action portion of the current expansion layer.

11. The light-emitting device according to any one of claims 1-7, further comprising:
a first bridge electrode, on the side of the first semiconductor layer away from the second semiconductor layer, and insulated from the second semiconductor layer through an interlayer insulation layer;
a first electrode, electrically connected to the first semiconductor layer through the first bridge electrode; and
a second electrode, electrically connected to the second semiconductor layer, wherein a direction in which the first semiconductor layer and the second semiconductor layer are stacked with each other is a vertical direction, the first bridge electrode is on the side of the first semiconductor layer away from the second semiconductor layer, an orthographic projection of the first bridge electrode on a horizontal plane perpendicular to the vertical direction overlaps with a part of an orthographic projection of the first semiconductor layer on the horizontal plane, and does not overlap with an orthographic projection of the first action region of the central region on the horizontal plane.

12. The light-emitting device according to claim 11, wherein the orthographic projection of the first bridge electrode extends in a transverse direction towards the orthographic projection of the first semiconductor layer to overlap with the orthographic projection of the first semiconductor layer, and a width of an overlapping part of the orthographic projection of the first bridge electrode and the orthographic projection of the first semiconductor layer in the transverse direction is less than half of a width of the first semiconductor layer in the transverse direction.

13. The light-emitting device according to claim 11 or 12, wherein upon the light-emitting device being transferred using the needle, the needle is located in the first action region, and an edge of the orthographic projection of the first bridge electrode on the horizontal plane close to the first action region comprises a concave portion depressed in a direction away from the first region.

14. The light-emitting device according to claim 13, wherein a shape of the concave portion of the edge of the orthographic projection of the first bridge electrode on the horizontal plane is complementary to a shape of an outer contour of an edge, opposite to the first bridge electrode, of an orthographic projection in the first action region on the horizontal plane.

15. The light-emitting device according to claim 13 or 14, wherein the shape of the concave portion of the edge of the orthographic projection of the first bridge electrode on the horizontal plane is an arc shape depressed in a direction away from the first action region.

16. The light-emitting device according to any one of claims 1-15, wherein the light-emitting device comprises a plurality of sub light-emitting units, each of the sub light-emitting units comprises a first semiconductor layer and a second semiconductor layer stacked with the first semiconductor layer and being made of a different material from the first semiconductor layer, the plurality of sub light-emitting units comprise a sub light-emitting unit for transfer, and the sub light-emitting unit for transfer further comprises the protection layer.

17. The light-emitting device according to claim 16, wherein odd numbered sub light-emitting units that are continuously arranged constitute a light-emitting unit, and the sub light-emitting unit for transfer is located in a middle position of the odd numbered sub light-emitting units.

18. The light-emitting device according to claim 16 or 17, wherein the plurality of sub light-emitting units comprise a first sub light-emitting unit adjacent to the sub light-emitting unit for transfer;
the light-emitting device further comprises a second bridge electrode, the second bridge electrode electrically connects the first semiconductor layer of the sub light-emitting unit for transfer and the second semiconductor layer of the first sub light-emitting unit.

19. The light-emitting device according to claim 18, wherein the second bridge electrode is further used as the protection layer.

20. The light-emitting device according to claim 16, wherein the plurality of sub light-emitting units comprise a second light-emitting unit and a third sub light-emitting unit that are adjacent to each other, a gap is between the second light-emitting unit and the third sub light-emitting unit, and a second action region where the needle is located is within the gap, upon the light-emitting device being transferred using the needle, the needle is located in the second action region;
the light-emitting device further comprises a second bridge electrode, the second bridge electrode electrically connects the first semiconductor layer of the second light-emitting unit and the second semiconductor layer of the third sub light-emitting unit, a direction in which the first semiconductor layer and the second semiconductor layer are stacked with each other is a vertical direction, an orthographic projection of the second bridge electrode on a horizontal plane perpendicular to the vertical direction does not overlap with an orthographic projection of the second action region where the needle is located on the horizontal plane.

21. The light-emitting device according to claim 20, wherein the second light-emitting unit and the third sub light-emitting unit are arranged in a transverse direction, and a direction perpendicular to the transverse direction in an extending plane of the second semiconductor layer is a longitudinal direction;
the second bridge electrode extends in the transverse direction and is on a side of the second action region in the longitudinal direction.

22. The light-emitting device according to claim 21, wherein an edge of an orthographic projection of the second bridge electrode on the horizontal plane close to the second action region comprises a concave portion depressed in a direction away from the second action region.

23. The light-emitting device according to claim 22, wherein a shape of the concave portion of the edge of the orthographic projection of the second bridge electrode on the horizontal plane is complementary to a shape of an outer contour of an edge, opposite to the second bridge electrode, of an orthographic projection in the second action region on the horizontal plane.

24. The light-emitting device according to any one of claims 20-23, wherein a first edge of the second semiconductor layer of the second sub light-emitting unit close to the third sub light-emitting unit in the transverse direction is closer to the gap than a first edge of the first semiconductor layer of the second sub light-emitting unit close to the third sub light-emitting unit in the transverse direction, and a first edge of the second semiconductor layer of the third sub light-emitting unit close to the second sub light-emitting unit in the transverse direction is closer to the gap than a first edge of the first semiconductor layer of the third sub light-emitting unit close to the second sub light-emitting unit in the transverse direction,
the first edge of the second semiconductor layer of the second sub light-emitting unit comprises a concave portion depressed in a direction away from the third sub light-emitting unit, and the first edge of the second semiconductor layer of the third sub light-emitting unit comprises a concave portion depressed in a direction away from the second sub light-emitting unit.

25. The light-emitting device according to claim 24, wherein an edge of the orthographic projection of the first semiconductor layer of the second sub light-emitting unit on the horizontal plane and an edge of the orthographic projection of the first semiconductor layer of the third sub light-emitting unit on the horizontal plane that are opposite to each other respectively comprise a concave portion depressed in a direction away from the gap; and/or,
an edge of the orthographic projection of the light-emitting layer of the second sub light-emitting unit on the horizontal plane and an edge of the orthographic projection of the light-emitting layer of the third sub light-emitting unit on the horizontal plane that are opposite to each other respectively comprise a concave portion depressed in a direction away from the gap.

26. The light-emitting device according to any one of claims 18-25, wherein a cross-section of the second bridge electrode along the vertical direction comprises a first sloping surface, an included angle between the first sloping surface and a horizontal direction is less than or equal to 70°, and the horizontal direction is perpendicular to the vertical direction.

27. The light-emitting device according to any one of claims 1-26, wherein a direction in which the first semiconductor layer and the second semiconductor layer are stacked with each other is a vertical direction, and a cross-section of the second semiconductor layer along the vertical direction comprises a second sloping surface, an included angle between the second sloping surface and a horizontal direction is less than or equal to 70°, and the horizontal direction is perpendicular to the vertical direction.

28. The light-emitting device according to any one of claims 1-27, wherein the light-emitting device is a mini light-emitting diode (Mini LED) or a micro light-emitting diode (Micro LED);
a material of the current expansion layer is a transparent conductive material;
the first semiconductor material is a P-type semiconductor material, and the second semiconductor material is an N-type semiconductor material, or,
the first semiconductor material is an N-type semiconductor material, and the second semiconductor material is a P-type semiconductor material.

29. A light-emitting device, comprising a plurality of sub light-emitting unit, wherein each of the sub light-emitting units comprises:
a first semiconductor layer;
a second semiconductor layer, stacked with the first semiconductor layer and being made of a different material from the first semiconductor layer;
a light-emitting layer, between the first semiconductor layer and the second semiconductor layer and configured to emit light,
wherein the plurality of sub light-emitting units comprise a second light-emitting unit and a third sub light-emitting unit that are adjacent to each other, a gap is between the second light-emitting unit and the third sub light-emitting unit, a second action region where the needle is located is within the gap, and upon the light-emitting device being transferred using the needle, the needle is located in the second action region;
the light-emitting device further comprises a second bridge electrode, the second bridge electrode electrically connects the first semiconductor layer of the second light-emitting unit and the second semiconductor layer of the third sub light-emitting unit, a direction in which the first semiconductor layer and the second semiconductor layer are stacked with each other is a vertical direction, an orthographic projection of the second bridge electrode on a horizontal plane perpendicular to the vertical direction does not overlap with an orthographic projection of the second action region where the needle is located on the horizontal plane.

30. Abacklight apparatus, comprising the light-emitting device according to any one of claims 1-29.

31. A display apparatus, comprising the light-emitting device according to any one of claims 1-29.
